# EUROPÄISCHE PATENTANMELDUNG

(11) **EP 2 607 978 A2**
(43) Veröffentlichungstag der Anmeldung: **26.06.2013**
(21) Anmeldenummer: 12007749.0
(22) Anmeldetag: 15.11.2012
(51) Int. Cl.: G05D 3/10

(54) **Steuergerät für ein Solarelement, Steuersystem für ein Solarfeld, Solarfeld und Verfahren zum Steuern eines Solarelements**

(30) Priorität: 24.12.2011 DE 102011122429
(71) Anmelder: ROBERT BOSCH GMBH, 70442 Stuttgart (DE)
(72) Erfinder: Herzig, Stephan, 97816 Lohr am Main (DE); Drikitis, Alexander Frank, 97816 Lohr am Main (DE)
(74) Vertreter: Wiesmann, Stephan

(57) **Zusammenfassung**

Ein Steuergerät (115) für ein Solarelement (103) eines Solarfeldes mit einer Mehrzahl von Solarelementen (103, 203) weist eine Solarelementschnittstelle zum Empfangen von Sensordaten des Solarelements (103) und zum Ausgeben von Antriebsdaten für einen Antrieb des Solarelements, ferner eine Kommunikationsschittstelle zum Empfangen einer Mehrzahl von Steuersignalen für die Mehrzahl von Solarelementen und zum Ausgeben von Betriebsdaten des Solarelements, wobei ein Steuersignal der Mehrzahl von Steuersignalen jeweils eine Adresse eines der Mehrzahl von Solarelementen umfasst und wobei die Betriebsdaten die Adresse des Solarelements umfassen, und ferner eine Verarbeitungseinrichtung auf, die ausgebildet ist, um aus einem der Mehrzahl von Steuersignalen dem eine Adresse des Solarelements zugeordnet ist Steuerdaten zu entnehmen und basierend auf den Steuerdaten die Antriebsdaten zu erzeugen und die ferner ausgebildet ist, um basierend auf den Sensordaten und der Adresse des Solarelements die Betriebsdaten zu erzeugen.

## Beschreibung

Die vorliegende Erfindung bezieht sich auf ein Steuergerät für ein Solarelement, ein Steuersystem für ein Solarfeld, ein Solarfeld und auf ein Verfahren zum Steuern eines Solarelements.

Ein Solarfeld umfasst eine große Anzahl von Solarelementen, beispielsweise in Form von Heliostaten, die gemeinsam mittels eines Steuersystems angesteuert werden.

Es ist die Aufgabe der vorliegenden Erfindung ein verbessertes Steuergerät für ein Solarelement, ein verbessertes Steuersystem für ein Solarfeld, ein verbessertes Solarfeld und ein verbessertes Verfahren zum Steuern eines Solarelements zu schaffen.

Diese Aufgabe wird durch ein Steuergerät für ein Solarelement, ein Steuersystem für ein Solarfeld, ein Solarfeld und ein Verfahren zum Steuern eines Solarelements gemäß den Hauptansprüchen gelöst.

Ein Steuergerät eines Solarelements kann so ausgeführt werden, dass es zum einen von einer zentralen Steuervorrichtung Steuerdaten zum Steuern einer Funktion des Solarelements empfangen und verwenden kann und zum anderen Messwerte oder Zustandsdaten des Solarelements an die zentrale Steuervorrichtung aussenden kann. Damit Steuergeräte mehrerer Solarelemente über einen gemeinsamen Kommunikationsweg mit der zentralen Steuervorrichtung kommunizieren können, kann jedem Steuergerät oder jedem Solarelement eine eindeutige Adresse zugewiesen werden.

Ein Vorteil eines gemeinsamen Kommunikationswegs besteht darin, dass sich der Verkabelungsaufwand auf ein Minimum reduzieren lässt. Gleichzeitig können einfache Standardkomponenten einer speicherprogrammierbaren Steuerung (SPS), wie digitale IO-Module oder Buskoppler, sowie eine zentrale Steuerung verwendet werden.

Sind die Steuergeräte mehrerer Solarelemente über einen gemeinsamen Datenbus miteinander verbunden, so entstehen im Vergleich zu einer Sterntopologie mit Direktverkabelung nur gering Verkabelungs- bzw. Inbetriebnahmekosten. Im Vergleich zu einer konventionellen seriellen Schnittstelle, z. B. einer RS-485 Schnittstelle, entfallen Kosten für zusätzliche Busklemmen.

Ein Steuergerät für ein Solarelement eines Solarfeldes mit einer Mehrzahl von Solarelementen und einer Mehrzahl von Steuergeräten weist folgende Merkmale auf:
eine Solarelementschnittstelle zum Empfangen von Sensordaten des Solarelements und zum Ausgeben von Antriebsdaten für einen Antrieb des Solarelements;
eine Kommunikationsschnittstelle zum Empfangen einer Mehrzahl von Steuersignalen für die Mehrzahl von Steuergeräten für die Mehrzahl von Solarelementen und zum Ausgeben von Betriebsdaten des Solarelements, wobei ein Steuersignal der Mehrzahl von Steuersignalen jeweils eine Adresse eines der Mehrzahl von Steuergeräten umfasst und wobei die Betriebsdaten die Adresse des Steuergeräts umfassen; und
eine Verarbeitungseinrichtung, die ausgebildet ist, um aus einem der Mehrzahl von Steuersignalen dem die Adresse des Steuergeräts zugeordnet ist Steuerdaten zu entnehmen und basierend auf den Steuerdaten die Antriebsdaten zu erzeugen und die ferner ausgebildet ist, um basierend auf den Sensordaten und der Adresse des Steuergeräts die Betriebsdaten zu erzeugen.

Das Solarfeld kann Teil eines Sonnenwärmekraftwerks sein. Dabei kann Sonnenlicht mithilfe der Mehrzahl von Solarelementen auf einen Absorber gebündelt werden. Ein Sonnenwärmekraftwerk kann beispielsweise als Solarturmkraftwerk ausgeführt sein. Das Solarelement kann ein Heliostat sein. Das Solarelement kann beispielsweise als Fresnel-Spiegel-Kollektor, als Paraboloid oder als Parabolrinne ausgeführt sein. Auch kann das Solarelement Solarzellen zur Erzeugung elektrischer Energie aufweisen. Das Steuergerät kann an oder benachbart zu dem Solarelement angeordnet sein. Das Steuergerät kann eingesetzt werden, um einen oder mehrere Antriebe des Solarelements und einen oder mehrere Sensoren oder Messwertgeber des Solarelements anzusteuern. Beispielsweise kann der Antrieb des Solarelements durch das Steuergerät so angesteuert werden, das das Solarelement dem Sonnenstand nachgeführt wird. Die Steuerung der Mehrzahl von Solarelementen kann dabei von einer zentralen Steuervorrichtung aus erfolgen. Die zentrale Steuervorrichtung kann ausgebildet sein, um für jedes Solarelement ein geeignetes Steuersignal zu erzeugen und an die Steuergeräte der Solarelemente auszugeben. Dabei können jedem Solarelement ein oder mehrere Steuergeräte zugeordnet sein. Beispielsweise kann ein Steuergerät pro Antrieb des Solarelements vorgesehen sein. Das Steuergerät einer Solaranlage kann ausgebildet sein, um ein Steuersignal der zentralen Steuervorrichtung zu empfangen und in zur tatsächlichen Ansteuerung eines Antriebs des Solarelements geeignete Antriebsdaten umzuwandeln. Dem Solarelement oder dem Steuergerät eines Solarelements kann eine eindeutige Adresse zugeordnet sein. Die Adresse kann der Steuervorrichtung bekannt sein, sodass das Steuersignal der Steuervorrichtung mit der Adresse versehen werden kann. Auf diese Weise können mehrere Steuergeräte über ein und denselben Übertragungsweg angesteuert und über deren Adresse unterschieden werden. Es ist demnach nicht erforderlich, das getrennte Leitungen von den Steuergeräten zu der zentralen Steuervorrichtung oder einem der Steuervorrichtung nachgeschalteten Verteiler geführt sind. Bei der Solarelementschnittstelle kann es sich um eine in Hardware ausgeführte Schnittstelle handeln. Das Steuergerät kann über elektrische Leitungen mit dem Antrieb sowie einem Sensor oder Messwertgeber verbunden sein. Der Antrieb kann als ein Elektromotor ausgeführt sein. Der Sensor kann beispielsweise als Temperatursensor, Drucksensor, Strommesser, Spannungsmesser oder Positionsgeber ausgeführt sein. Die Kommunikationsschnittstelle kann in Hardware ausgeführt sein. Das Steuergerät kann über die Kommunikationsschnittstelle mit der zentralen Steuervorrichtung oder einem der zentralen Steuervorrichtung nachgeschalteten Verteiler, beispielsweise über elektrische Leitungen oder eine drahtlose Verbindung verbunden sein. Steuergerät mehrere Solarelemente können seriell verbunden sein, sodass die Kommunikationsschnittstelle eine Bus-Schnittstelle, beispielsweise zu einem CAN-Bus sein kann. Somit können Datenpakete an mehrere Steuergeräte mehrerer Solarelemente unter Verwendung eines geeigneten Übertragungsprotokolls über ein und dieselbe Leitung an die Steuergeräte übertragen werden. Ebenso können Datenpakete der mehreren Steuergeräte unter Verwendung des Übertragungsprotokolls über ein und dieselbe Leitung an die zentrale Steuervorrichtung übertragen werden. Je nach Übertragungsprotokoll können die gleiche oder unterschiedliche Leitungen zum Senden und Empfangen der Datenpakete eingesetzt werden. Jedes Datenpaket kann die Adresse desjenigen Steuergeräts umfassen, für das oder von dem das Datenpaket erzeugt wurde. Über die Kommunikationsschnittstelle können die Betriebsdaten des Solarelements, die beispielsweise von dem Sensor oder dem Messwertgeber erfasste Werte umfassen, an die zentrale Steuervorrichtung ausgegeben werden. Die Verarbeitungseinrichtung kann als eine Logikeinheit in Hardware oder in Software ausgeführt sein. Die Verarbeitungseinrichtung kann ausgebildet sein, um über die Solarelementschnittstelle und die Kommunikationsschnittstelle empfangenen Daten zu verarbeiten und als verarbeitete Daten zur Ausgabe an die die Solarelementschnittstelle und die Kommunikationsschnittstelle bereitstellen. Die Verarbeitungseinrichtung kann Zugriff auf die Adresse des Steuergeräts oder des Solarelements haben und die Adresse nutzen, um über die Kommunikationsschnittstelle empfangene Datenpakete, die die eigene Adresse des Steuergeräts oder des Solarelements umfassen, als zu verwendende Datenpakete zu identifizieren und andere empfangene Datenpakete, die eine fremde Adresse umfassen, als nicht zu verwendende Datenpakete zu verwerfen oder, beispielsweise an ein weiteres Steuergerät weiterzuleiten. Ferner kann die Verarbeitungseinrichtung die Adresse verwenden, um in der Verarbeitungseinrichtung erzeugte Datenpakete, die beispielsweise die Betriebsdaten umfassen, vor dem Aussenden über die Kommunikationsschnittstelle mit der eigenen Adresse zu versehen.

Die Kommunikationsschnittstelle kann eine digitale Schnittstelle sein. Somit kann die Kommunikationsschnittstelle zumindest einen Eingang zum Empfangen eines digitalen Signals und einen Ausgang zum Ausgeben eines digitalen Signals oder einen bidirektionalen Anschluss zum Empfangen und Ausgeben eines digitalen Signals aufweisen. Die Solarelementschnittstelle kann mindestens eine digitale Schnittstelle und mindestens eine analoge Schnittstelle umfassen. Somit können über die Solarelementschnittstelle sowohl analoge als auch digitale Signale empfangen und ausgegeben werden. Dadurch kann die Solarelementschnittstelle flexibel eingesetzt werden.

Das Steuergerät kann eine Eingabeschnittstelle zum Eingeben der Adresse des Steuergeräts aufweisen. Ferner kann das Steuergerät einen Speicher zum Speichern der Adresse aufweisen. Über die Eingabeschnittstelle kann jedem Steuergerät der Mehrzahl von Solarelementen eine eigne Adresse zugewiesen werden. Die Eingabeschnittstelle kann als eine digitale Schnittstelle (LIO- Bus oder Programmierschnittstelle) oder eine mechanische Schnittstelle ausgeführt sein, über die die Adresse einprogrammiert werden kann. Beispielsweise kann die Eingabeschnittstelle einen Dipschalter umfassen. Aus dem Speicher kann die Adresse bei Bedarf ausgelesen werden.

Die Steuerdaten können einen Sollwert für den Antrieb des Solarelements umfassen und die Verarbeitungseinrichtung kann ausgebildet sein, um die Antriebsdaten zum Einstellen des Antriebs auf den Sollwert zu erzeugen. Die Sensordaten können einen Istwert des Antriebs umfassen und die Verarbeitungseinrichtung kann ausgebildet sein, um den Istwert in die Betriebsdaten einzufügen. Auf diese Weise kann das Steuergerät zum einen eingesetzt werden, um den Antrieb anzusteuern und zum anderen eingesetzt werden, um den Antrieb zu überwachen.

Die Kommunikationsschnittstelle kann ausgebildet sein, um eine Mehrzahl von Datenpaketen zu empfangen und wieder auszugeben. Dabei kann ein Datenpaket jeweils eine Adresse eines der Mehrzahl von Steuergeräte umfassen. Die Verarbeitungseinrichtung kann ausgebildet sein, um die Steuerdaten aus einem Datenpaket, dem die Adresse des Steuergeräts zugeordnet ist zu entnehmen und die Betriebsdaten in das Datenpaket einzufügen, dem die Adresse des Steuergeräts zugeordnet ist. Auf diese Weise kann das Steuergerät aus einer Mehrzahl von empfangenen Datenpaketen dasjenige Datenpaket auswählen, das von einer zentralen Steuervorrichtung für dieses Steuergerät ausgesendet wurde. Ferner kann sichergestellt werden, dass die zentrale Steuervorrichtung empfangene Datenpakete denjenigen Steuergeräten zuordnen kann, von denen die Datenpakete erzeugt und nicht nur weitergeleitet wurden.

Beispielsweise kann die Kommunikationsschnittstelle eine Profi-Bus-Schnittelle, eine CAN-Bus-Schnittelle oder eine WLAN-Schnittelle sein. Auf diese Weise können bereits bewährte Übertragungsprotokolle zur Kommunikation zwischen dem Steuergerät und einer zentralen Steuervorrichtung oder einem der zentralen Steuervorrichtung nachgeschalteten Verteiler eingesetzt werden.

Ein Steuersystem für ein Solarfeld mit einer Mehrzahl von Solarelementen weist folgende Merkmale auf:
eine Mehrzahl von Steuergeräten gemäß beschriebenen Ausführungsformen, wobei eines der Mehrzahl von Steuergeräten jeweils einem der Mehrzahl von Solarelementen zugeordnet ist und eine Adresse des Steuergeräts aufweist; und
eine Steuervorrichtung zum Steuern der Mehrzahl von Solarelementen, wobei die Steuervorrichtung eine weitere Kommunikationsschnittstelle aufweist, zum Empfangen einer Mehrzahl von Betriebsdaten von der Mehrzahl von Steuergeräten und zum Ausgeben der Mehrzahl von Steuersignalen für die Mehrzahl von Solarelementen an die Mehrzahl von Steuergeräten.

Die Steuervorrichtung kann eine zentrale Einheit zum zentralen Steuern der Mehrzahl von Solarelementen sein. Beispielsweise kann die Steuervorrichtung ausgebildet sein, um die Mehrzahl von Solarelementen dem Sonnenstand nachzuführen. In einem Übertragungskanal für die Betriebsdaten und die Steuersignale zwischen der Steuervorrichtung und der Mehrzahl von Solarelementen kann ein Verteiler, beispielsweise ein Buskoppler angeordnet sein. Der Übertragungskanal kann zwischen der Steuervorrichtung und dem Verteiler und zwischen dem Verteiler und den Steuergeräten auf unterschiedlichen Übertragungsprotokollen basieren. Demnach kann ein Übertragungsformat der Betriebsdaten und der Steuersignale innerhalb des Übertragungskanals geändert werden.

Beispielsweise kann die Mehrzahl von Solarelementen in eine Anzahl von Gruppen von Solarelementen unterteilt sein und das Steuersystem kann eine der Anzahl von Gruppen entsprechende Anzahl von Verteilern aufweisen, die über einen gemeinsamen Datenübertragungsweg mit der Steuervorrichtung verbunden sind. Dabei kann einem Verteiler jeweils eine der Anzahl von Gruppen von Solarelementen zugeordnet sein. Ein Verteiler kann jeweils ausgebildet sein, um aus der Mehrzahl von Steuersignalen für die Mehrzahl von Solarelementen diejenigen Steuersignale, die Solarelementen der dem Verteiler zugeordneten Gruppe von Solarelementen zugeordnet sind, an die Steuergeräte der dem Verteiler zugeordneten Gruppe von Solarelementen weiterzuleiten. Ferner kann ein Verteiler jeweils ausgebildet sein, um die Betriebsdaten der dem Verteiler zugeordneten Gruppe von Solarelementen zu empfangen und an die Steuervorrichtung weiterzuleiten. Somit können die Mehrzahl von Solarelementen in Gruppen unterteilt sein, denen jeweils ein Verteiler zugeordnet ist. Die Verteiler sind wiederum mit der zentralen Steuervorrichtung gekoppelt, beispielsweise über eine gemeinsame Ethernet-Verbindung.

Ein Solarfeld weist folgende Merkmale auf:
eine Mehrzahl von Solarelementen, wobei jedes Solarelement ein Steuergerät gemäß einer beschriebenen Ausführungsform aufweist; und
ein Steuersystem für ein Solarfeld, das mit den Steuergeräten gekoppelt ist.

Ein Verfahren zum Steuern eines Solarelements eines Solarfeldes mit einer Mehrzahl von Solarelementen und einer Mehrzahl von Steuergeräten umfasst die folgenden Schritte:
Empfangen einer Mehrzahl von Steuersignalen für die Mehrzahl von Steuergeräten für die Mehrzahl von Solarelementen über eine Kommunikationsschnittstelle eines Steuergeräts des zu steuernden Solarelements, wobei ein Steuersignal der Mehrzahl von Steuersignalen jeweils eine Adresse eines der Mehrzahl von Steuergeräten umfasst;
Entnehmen von Steuerdaten aus einem der Mehrzahl von Steuersignalen dem eine Adresse des Steuergeräts des zu steuernden Solarelements zugeordnet ist;
Erzeugen von Antriebsdaten für einen Antrieb des zu steuernden Solarelements basierend auf den Steuerdaten;
Ausgeben der Antriebsdaten für den Antrieb des zu steuernden Solarelements über eine Solarelementschnittstelle des Steuergeräts des zu steuernden Solarelements;
Empfangen von Sensordaten des zu steuernden Solarelements über die Solarelementschnittstelle;
Erzeugen von Betriebsdaten, die die Adresse des Steuergeräts des zu steuernden Solarelements umfassen basierend auf den Sensordaten und der Adresse des Steuergeräts des zu steuernden Solarelements; und
Ausgeben der Betriebsdaten des zu steuernden Solarelements über die Kommunikationsschnittstelle.

Das Verfahren kann beispielsweise von Einrichtungen eines beschriebenen Steuergeräts ausgeführt werden.

Die Erfindung wird nachstehend anhand der beigefügten Zeichnungen beispielhaft näher erläutert. Es zeigen:
- Fig. 1: eine Darstellung eines Solarfelds;
- Figuren 2 bis 6: Darstellungen eines Solarfelds gemäß Ausführungsbeispielen der Erfindung;
- Fig. 7: ein Ablaufdiagramm eines Verfahrens gemäß einem Ausführungsbeispiel der Erfindung; und
- Fig. 8: ein Blockschaltbild einer Steuerung eines Solarfelds gemäß einem Ausführungsbeispiel der vorliegenden Erfindung.

Gleiche oder ähnliche Elemente können in den nachfolgenden Figuren durch gleiche oder ähnliche Bezugszeichen versehen sein. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden oder sie zu weiteren, hier nicht explizit beschriebenen Kombinationen zusammengefasst werden können.

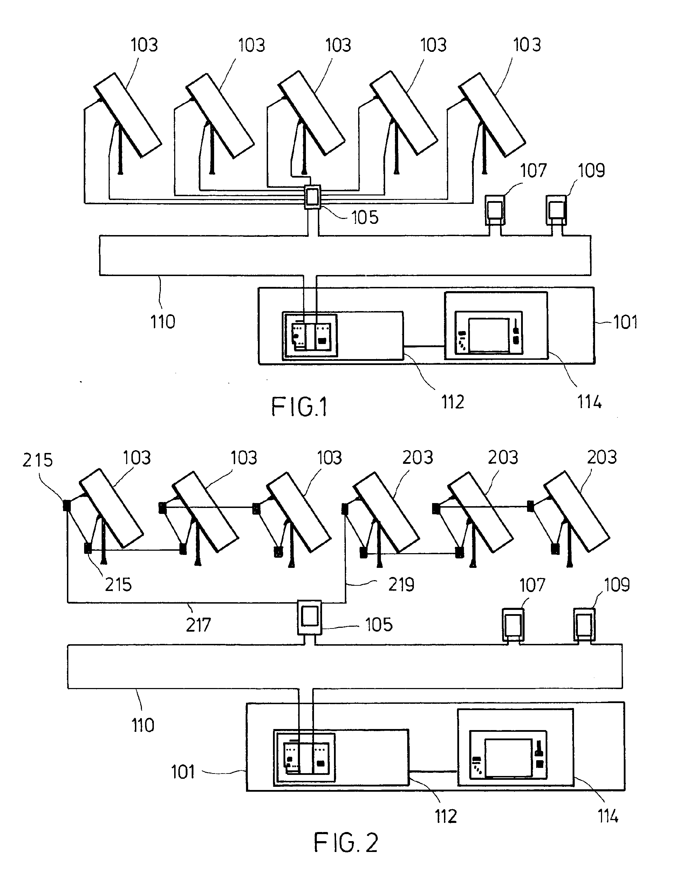

Fig. 1 zeigt eine Darstellung eines Solarfelds mit einer zentralen Steuervorrichtung 101 und einer Gruppe von Solarelementen 103, die über einen Verteiler in Form eines Buskopplers 105 mit der zentralen Steuervorrichtung 101 verbunden sind. Das Solarfeld weist weitere Buskoppler 107, 109 auf. Die weiteren Buskoppler 107, 109 sind für weitere in Fig. 1 nicht gezeigte Gruppen von Solarelementen vorgesehen. Die Buskoppler 105, 107, 109 sind über einen gemeinsamen Bus 110 mit der Steuervorrichtung 101 verbunden. Jedes der Solarelemente 103 ist über eigene Leitungen mit dem Buskoppler 105 verbunden.

Die Solarelemente 103 sind jeweils als ein Heliostat ausgeführt. Die Buskoppler 105, 107, 109 sind jeweils mit digitalen Eingängen und digitalen Ausgängen (DI / DO) versehen. Die Buskoppler 105, 107, 109 sind jeweils in einem Schaltschrank angeordnet. Die zentrale Steuervorrichtung 101 weist eine speicherprogrammierbare Steuerung 212 und ein Bediensystem 214 auf, die miteinander gekoppelt sind. Die speicherprogrammierbare Steuerung 210 ist über den Bus 110 mit den Buskopplern 105, 107, 109 verbunden. Bei dem Bus 110 handelt es sich einen Sercos III Bus (Serial Realtime Communication System Bus).

Das in Fig. 1 gezeigte Solarfeld basiert auf einer Sterntopologie mit Direktverdrahtung zur Ansteuerung einer großen Anzahl von Antrieben in einem weiten Solarfeld mit zentraler Steuerung 101. Gezeigt ist das Solarfeld mit Direktverdrahtung von ca. fünf Heliostaten 103 pro Cluster. Für die Direktverdrahtung ist ein hoher Verdrahtungs- und Inbetriebnahmeaufwand erforderlich und es entstehen hohe Kabelkosten. Hier sind acht Adern pro Antrieb erforderlich.

Fig. 2 zeigt eine Darstellung eines Solarfelds gemäß einem Ausführungsbeispiel der vorliegenden Erfindung. Das Solarfeld weist eine zentrale Steuervorrichtung 101 auf. Die zentrale Steuervorrichtung 101 ist ausgebildet, um eine erste Gruppe von Solarelementen 103, eine zweite Gruppe von Solarelementen 203, sowie weitere nicht gezeigte Gruppen von Solarelementen des Solarfelds zu steuern und zu überwachen. Beispielsweise ist die zentrale Steuervorrichtung 101 ausgebildet, um die Solarelemente 103, 203 in Bezug auf den Sonnenstand auszurichten. Zum Ausrichten der Solarelemente 103, 203 weisen diese jeweils Antriebe auf, die über Steuergeräte 215 angesteuert werden. Gemäß diesem Ausführungsbeispiel weist jedes Solarelement 103, 203 jeweils zwei Steuergeräte 215 auf. Der Übersichtlichkeit halber sind nur die beiden Steuergeräte 215 des links gezeigten Solarelements mit Bezugszeichen versehen. Steuergeräte 215 eines Solarelements 103, 203 können gleich oder unterschiedlich sein. Ebenso können Steuergeräte 215 unterschiedlicher Solarelemente 103, 203 gleich oder unterschiedlich ausgeführt sein.

Die Steuergeräte 215 der ersten Gruppe von Solarelementen 103 sind über einen Verteiler in Form eines Buskopplers 105 mit der zentralen Steuervorrichtung 101 verbunden. Die Steuergeräte 215 der ersten Gruppe von Solarelementen 103 sind über einen gemeinsamen ersten Bus 217 miteinander und mit dem Buskoppler 105 verbunden. Dabei sind Leitungen des ersten Bus 217 von dem Buskoppler 105 zu einem ersten Steuergerät eines ersten Solarelements 103 der ersten Gruppe, von dem ersten Steuergerät 115 des ersten Solarelements 103 zu einem zweiten Steuergerät 115 des ersten Solarelements 103, von dem zweiten Steuergerät 115 des ersten Solarelements 103 zu einem ersten Steuergerät 115 eines zweiten Solarelements 103 der ersten Gruppe, von dem ersten Steuergerät 115 des zweiten Solarelements 103 zu einem zweiten Steuergerät 115 des zweiten Solarelements 103, von dem zweiten Steuergerät 115 des zweiten Solarelements 103 zu einem ersten Steuergerät 115 eines dritten Solarelements 103 der ersten Gruppe und von dem ersten Steuergerät 115 des dritten Solarelements 103 zu einem zweiten Steuergerät 115 des dritten Solarelements 103 geführt. Somit sind über den ersten Bus 217 alle Steuergeräte 215 aller Solarelemente 103 einer Gruppe miteinander verbunden.

Die Steuergeräte 215 der zweiten Gruppe von Solarelementen 203 sind ebenfalls über den Buskoppler 105 mit der zentralen Steuervorrichtung 101 verbunden. Die Steuergeräte 215 der zweiten Gruppe von Solarelementen 203 sind über einen gemeinsamen zweiten Bus 219 miteinander und mit dem Buskoppler 105 verbunden. Der zweite Bus 219 ist entsprechend dem ersten Bus 217 ausgeführt. Der Buskoppler 105 weist zwei Schnittstellen für den ersten Bus 217 und den zweiten Bus 219 sowie eine Schnittstelle für den Bus 110 auf.

Die weiteren Buskoppler 107, 109 weisen entsprechende Schnittstellen für den Bus 110 sowie für weitere Busse für weitere nicht gezeigte Gruppen von Solarelementen auf.

Gemäß diesem Ausführungsbeispiel sind die Solarelemente 103, 203 jeweils als ein Heliostat ausgeführt. Jedes Solarelement 103, 203 weist eine reflektierende Fläche zum Reflektieren von Sonnenlicht auf. Die reflektierende Fläche, beispielsweise ein Spiegel ist auf einem Ständer angeordnet und kann durch Antriebe in ihrer Ausrichtung verändert werden. Pro Antrieb eines Solarelements 103, 203 ist gemäß diesem Ausführungsbeispiel ein Steuergerät 115 vorgesehen. Jedem Steuergerät 115 ist eine eindeutige Adresse zugewiesen, die innerhalb eines Busprotokolls der Busse 217, 219 zur Identifizierung der Steuergeräte 115 verwendet wird.

Die Buskoppler 105, 107, 109 sind jeweils mit digitalen Eingängen und digitalen Ausgängen (DI / DO) versehen. Die Buskoppler 105, 107, 109 sind jeweils in einem Schaltschrank angeordnet. Die Busse 217, 219 sind als LIO- Busse (Local Input Output Busse) ausgeführt. Demnach weisen die Steuergeräte 115 jeweils ein LIO- Bus Interface also eine LIO- Bus Schnittstelle auf.

Die zentrale Steuervorrichtung 101 weist eine speicherprogrammierbare Steuerung 212 und ein Bediensystem 214 auf. Die Steuerung 212 und das Bediensystem 214 sind über eine Leitung miteinander gekoppelt. Das Bediensystem 114 weist eine Benutzerschnittstelle auf, über die die Steuervorrichtung 101 von einer Bedienperson gesteuert werden kann. Die speicherprogrammierbare Steuerung 210 ist über den Bus 110 mit den Buskopplern 105, 107, 109 verbunden. Bei dem Bus 110 handelt es sich um einen Ringbus mit einer Ringleitung in der die Buskoppler 105, 107, 109 seriell angeordnet sind. Jedem der Buskoppler 105, 107, 109 ist eine eindeutige Adresse zugewiesen, die innerhalb eines Busprotokolls des Bus 110 zur Identifizierung der Buskoppler 105, 107, 109 verwendet wird. Die Steuervorrichtung 101 weist eine entsprechende eindeutige Adresse auf. Der Bus 110 kann auf einem Ethernet-Bus Protokoll basieren. Der Bus 110 ist gemäß diesem Ausführungsbeispiel als ein Sercos III Bus ausgeführt.

Um einen Antrieb eines Sensorelements 103, 105 anzusteuern ist, die Steuervorrichtung 101 ausgebildet, um ein Steuersignal mit der Adresse des Steuergeräts 115 des entsprechenden Antriebs und der Adresse des Buskopplers 105, 107, 109, der der Gruppe des entsprechenden Sensorelements 103, 203 zugeordnet ist über den Bus 110 auszusenden. Der Buskoppler 105, 107, 109 mit der entsprechenden Adresse des Steuersignals ist ausgebildet, um das Steuersignal zu empfangen und beispielsweise über den Bus 217, in dem das entsprechende Steuergerät 115 angeordnet ist auszugeben. Der Buskoppler 105, 107, 109 kann ausgebildet sein, um ein Übertragungsformat des von der Steuervorrichtung empfangenen Steuersignals an ein Übertragungsformat des Bus 217, 219 anzupassen. Somit können sich das von dem Buskoppler 105, 107, 109 über den Bus 110 empfangene Steuersignal und das von dem Buskoppler 105, 107, 109 an den Bus 217, 219 ausgegebene Steuersignal in ihrem Übertragungsformat unterscheiden. Das von dem Buskoppler 105, 107, 109 ausgesendete Steuersignal weist die Adresse des entsprechenden Steuergeräts 215 auf. Das entsprechende Steuergerät 215 ist ausgebildet, um aus dem über den Bus 217, 219 empfangenen Steuersignal Steuerdaten für den entsprechenden Antrieb zu entnehmen und daraus Antriebsdaten zum Antreiben des Antriebs zu erzeugen und an den Antrieb auszugeben.

Um Daten eines Sensors eines Solarelements 103, 105 an die Steuervorrichtung 101 zu übertragen, ist das Steuergerät 115, dem der entsprechende Sensor zugeordnet ist, ausgebildet, um Sensordaten des Sensors zu empfangen und in Form von Betriebsdaten, die sowohl mit der Adresse des entsprechenden Steuergeräts als auch mit der Adresse der Steuervorrichtung 101 versehen sind auf den Bus 217, 219 auszugeben. Der entsprechende Buskoppler 105, 107, 109 ist ausgebildet, um die Betriebsdaten zu empfangen und über den Bus 210 an die Steuervorrichtung 101 weiterzuleiten. Der Buskoppler 105, 107, 109 kann ausgebildet sein, um ein Übertragungsformat der von dem entsprechenden Steuergerät 115 empfangenen Betriebsdaten an ein Übertragungsformat des Bus 110 anzupassen. Die von dem Buskoppler 105, 107, 109 ausgegebenen Betriebsdaten weisen die Adresse des entsprechenden Steuergeräts 215 und der Steuervorrichtung 101 auf. Die Steuervorrichtung 101 ist ausgebildet, um die Betriebsdaten zu empfangen und auszuwerten.

Das in Fig. 2 gezeigte Ausführungsbeispiel basiert auf einem Local Input Output-Bus (LIO-Bus) 217, 219. Der LIO-Bus 217, 219 steuert die Peripherie-Module, bei denen es sich beispielsweise um einfache Antriebe oder Messumformer handeln kann, jeweils über einen Funktionsbaustein in der SPS Applikation 112 und den digitalen Input und Output Klemmen am Feldbuskoppler 105, 107, 109 an. Eine weitere Kommunikationseinheit am Buskoppler 105, 107, 109 ist nicht erforderlich. Lediglich die Antriebe enthalten ein LIO-Bus Interface 215 auf Basis eines Mikrocontrollers. Ein Buskoppler 105, 107, 109 kann mehrere lokale IO-Busse ansteuern. Entsprechend ist in Fig. 2 ein Solarfeld mit Lokal Input Output (LIO)-Bus und ca. fünf Heliostate 103, 203 pro einem Cluster gezeigt. Gemäß dem in Fig. 1 gezeigten Ausführungsbeispiel umfasst ein Cluster zwei mal drei, also sechs Heliostate 103, 203. Vorteilhafterweise sind gemäß diesem Ausführungsbeispiel nur noch vier Adern pro Antrieb erforderlich und die Kabellängen reduzieren sich im Vergleich zu dem in Fig. 1 gezeigten Ausführungsbeispiel um ca. 80%.

Im Folgenden wird anhand von Fig. 2 ein lokales Peripherie Bussystem für Solarfelder basierend auf digitalen Ein- und Ausgängen gemäß einem Ausführungsbeispiel der vorliegenden Erfindung beschrieben. Dabei findet ein Datenaustausch im Solarfeld zwischen Buskopplern und elektrischen Antrieben zur Minimierung der Verkabelungskosten statt. Als Basis kann ein zweiachsiges Trackingsystem für Heliostaten 103, 203 mit Sercos III Schnittstelle zur Datenübertragung und Ansteuerung der Antriebe der Heliostaten 103, 203 eingesetzt werden. Das gezeigte Kommunikationskonzept eignet sich zur Ansteuerung einer großen Anzahl von Teilnehmern in großen Solarfeldern, wie Turm, Fresnel, Paraboloide oder Parabolrinne, bei geringen Anforderungen an die Übertragungsrate. Dadurch ergeben sich eine Einsparung von Leitungs-, Hardware- (SPS IO- bzw. Kommunikationsmodule) und Inbetriebnahmekosten. Die Ansteuerung der Antriebe erfolgt über einen einfachen seriellen Bus 217, 219 der keine Kommunikationsklemme benötigt, stattdessen bereits vorhanden digitale IO's am Sercos Buskopper 105, 107, 109 verwendet. Aufseiten der SPS-Steuerung 112 wird ein Telegramm, mit dem Daten zwischen der Steuervorrichtung 101 und den Steuergeräten 115 ausgetauscht werden, über ein Feldbusprotokoll eines Feldbus (FB) 110 realisiert.

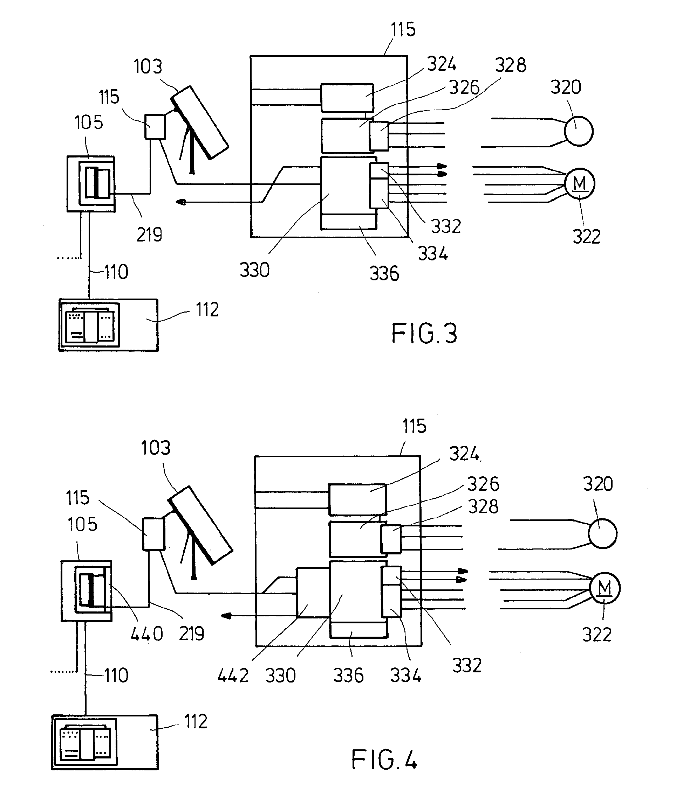

Fig. 3 zeigt eine Detaildarstellung des in Fig. 2 gezeigten Solarfelds gemäß einem Ausführungsbeispiel der vorliegenden Erfindung. Gezeigt ist entsprechend zu Fig. 2 ein Solarelement 103, ein Buskoppler 105 und eine speicherprogrammierbare Steuerung 112. Ferner ist ein Steuergerät 115 des Solarelements 103 und ein Steuergerät 115 eines weiteren in Fig. 3 nicht gezeigten Solarelements 103 gezeigt. Die speicherprogrammierbare Steuerung 112 ist über einen Bus 110 in Form eines Sercos III / Ethernet-Bus mit dem Buskoppler 105 und weiteren in Fig. 3 nicht gezeigten Buskopplern verbunden. Der Buskoppler 105 ist über einen Bus 219, in Form eines LIO-Bus mit den Steuergeräten 115 und weitern in Fig. 3 nicht gezeigten Steuergeräten verbunden. Das in einer Detaildarstellung gezeigte Steuergerät 115 ist mit einem Sensor 320, beispielsweise einem Temperatursensor, und zusätzlich oder alternativ mit einem Motor 322, z. B. einem Linearantrieb, verbunden.

Das Steuergerät 115 in Form eines LIO-Bus Interface weist einen Gleichstromwandler 324 auf, der mit einem +24V und einem 0V Anschluss des Steuergeräts 115 verbunden ist. Das Steuergerät 115 weist einen Analog-Digital-Wandler 326 auf, der über einen Analog Input 328 mit dem Sensor 320 verbunden ist. Der Analog-Digital-Wandler 326 kann ausgebildet sein, um analoge Daten des Sensors 320 in digitale Signale zu wandeln, und beispielsweise an einen Mikrocontroller 330 des Steuergeräts 115 bereitzustellen. Gemäß diesem Ausführungsbeispiel weist der Analog Input 328 einen Eingang für ein Stromsignal, beispielsweise im Bereich von 4mA bis 20mA, einen Eingang für ein Spannungssignal, beispielsweise im Bereich von 0V bis 10V und einen Masseanschluss GND auf. Der Mikrocontroller 330 ist über einen Sendeanschluss (Send) mit einer Leitung des LIO-Bus 219 und über einen Empfangsanschluss (Receive) mit einer weiteren Leitung des LIO-Bus 219 verbunden. Der Mikrocontroller 330 ist über einen Digital Output 332 und einem Digital Input 334 mit dem Motor 322 verbunden. Der Digital Output 322 umfasst einen Ausgang L für eine Ansteuerung des Motors 322 in eine Richtung "links" und einen Ausgang R für eine Ansteuerung des Motors 322 in eine entgegengesetzte Richtung "rechts". Der Digital Input 334 umfasst einen Eingang für ein Signal eines ersten Hall-Sensors A, einen Eingang für ein Signal eines zweiten Hall-Sensors B und einen Eingang für ein Signal eines Endschalters, eines sogenannten Limit Switch (LS). Über die Signale der Hall-Sensoren kann ein Zustand des Motors 322 erfasst werden. Das Steuergerät 115 weist eine eindeutige Adresse 336 auf, die in einem geeigneten Speicher gespeichert sein kann. Der Mikrocontroller 330 ist ausgebildet, um die Adresse 336 auszulesen.

Das anhand von Fig. 3 beschriebene Ausführungsbeispiel basiert auf einem Local Input Output - Bus Interface 215.

Das LIO-Bus Interface 215 weist bezüglich des Antriebs 322 folgende Hauptfunktionen auf. Zum einen einen Empfang der Sollposition des Antriebs 322. Des Weiteren ein Ansteuern der digital Ausgänge (L / R) zum Positionieren des Motor 322 auf die Sollposition. Ferner ein Einlesen und Zählen der Hall Impulse des Motors 322. Ferner umfassen die Hauptfunktionen ein Senden der aktuellen Istposition des Antriebs 322 an den Buskoppler 105 bzw. die SPS 112. Wenn er Endschalter betätigt ist, wird die Position des Antriebs 322 auf "0" gesetzt, also zurückgesetzt. Bei Busausfall erfolgt eine Ansteuerung des Motors 322 in eine definierte Position.

Das LIO-Bus Interface 215 weist bezüglich des Sensors 320 als Hauptfunktion das Senden eines Messwerts des Sensors 320 auf.

Die Adresse 336 des Interface 215 wird einmalig über z. B. einen Dipschalteblock 8 Bit eingestellt. Jede Adresse darf in einem LIO-Bus Loop 219 nur einmal vergeben werden.

Die Positioniergeschwindigkeit ist unabhängig von der SPS-Zykluszeit der Steuerung 112, da die Positionierung des Antriebs 322 vom Mikrocontroller 330 nach Erhalt einer neuen Sollposition vorgenommen wird. Dadurch kann die SPS 112 eine viel höhere Anzahl an Teilnehmern 115 verwalten.

Das Solarelement 103 ist gemäß diesem Ausführungsbeispiel als eine solare Verstelleinheit, z. B. ein Heliostat ausgeführt.

Im Folgenden wird anhand von Fig. 3 ein lokales Interface mit serieller Schnittstelle zum Ansteuern von Antrieben 322 und zur Messwerterfassung gemäß einem Ausführungsbeispiel der vorliegenden Erfindung beschrieben. Dabei findet ein Datenaustausch im Solarfeld zwischen Buskopplern 105 und elektrischen Antrieben 322 zur Minimierung der Verkabelungskosten statt. Als Basis kann ein zweiachsiges Trackingsystem für Heliostaten 103 mit Sercos III Schnittstelle zur Datenübertragung und Ansteuerung der Antriebe 322 eingesetzt werden. Das gezeigte Interface 115 dient sowohl zum Ansteuern von einem bis 128 langsam verstellbaren Antrieben 322 in Solarfeldern als auch zum Einlesen von Prozessmesswerten, wie Temperatur, Druck, Winkel, Strom oder Spannung. Dadurch ergeben sich eine Einsparung von Leitungs-, Hardware- (SPS analog IO, digital IO- bzw. Kommunikationsmodule) und Inbetriebnahmekosten. Es wird kein Buskoppler mit Direktverkabelung, d. h. die lokale Peripherie wird direkt an einen entsprechend mit IO-Modulen bestückten Buskoppler angeschlossen, eingesetzt. Dadurch können hohe Verkabelungs- bzw. Inbetriebnahmekosten sowie Kosten für analoge und digitale IO-Module vermieden werden. Stattdessen erfolgt eine Ansteuerung von mehreren tausend Antrieben 322 und eine Messwertaufnahme von diversen Messwertgebern 320 (Temperatur, Strom, Spannung, etc.) in einem Solarfeld bei geringstem Kosten- und Inbetriebnahmeaufwand. Das Interface 115 hat eine Adresse 336 und kommuniziert über ein einfaches Datenprotokoll mit der SPS 112. Beim Antrieb 322 wird ein Sollwert vorgegeben und das Interface 115 schaltet den Motor 322 ein bis die Position erreicht ist. Der Istwert geht an die SPS 112 zurück. Das Interface 115 verfügt neben den digitalen auch über analoge Ein- bzw. Ausgänge. Damit kann es auch Messwerte (4..20mA / 0 .. 10V) von z. B. Temperatursensoren 320 aufnehmen und an die Steuerung 112 senden. Das Interface 115 minimiert den Verkabelungs- und Hardwareaufwand in Solarfeldern. Darüber hinaus können auch Antriebsfunktionen, wie z. B. Grundstellung bei Busausfall, realisiert werden. Außerdem kann die SPS 112 eine höhere Anzahl an Teilnehmern verwalten.

Die Ansteuerung der Antriebe erfolgt über einen einfachen seriellen Bus 217, 219 der keine Kommunikationsklemme benötigt, stattdessen bereits vorhanden digitale IO's am Sercos Buskopper 105, 107, 109 verwendet. Aufseiten der SPS-Steuerung 112 wird ein Telegramm, mit dem Daten zwischen der Steuervorrichtung 101 und den Steuergeräten 115 ausgetauscht werden, über ein Feldbusprotokoll eines Feldbus (FB) 110 realisiert.

Fig. 4 zeigt eine Detaildarstellung des in Fig. 2 gezeigten Solarfelds gemäß einem Ausführungsbeispiel der vorliegenden Erfindung. Das in Fig. 4 gezeigte Ausführungsbeispiel entspricht dem in Fig. 3 gezeigten Ausführungsbeispiel mit dem Unterschied, dass der Bus 219 nicht als LIO-Bus sondern als CAN-Bus ausgeführt ist. Entsprechend weist der Buskoppler 105 neben einem Sercos III-Bus bzw. einem Ethernet-Bus Kommunikationsmodul ein CAN Kommunikationsmodul 340 auf. Das Steuergerät 115 weist dem Mikrocontroller 430 vorgeschaltet einen CAN-Teiberbaustein 442, das über einen CAN High Anschluss und einen CAN Low Anschluss mit dem CAN-Bus 219 verbunden ist.

Das Ausführungsbeispiel basiert auf einem Solar Peripherie Interface (SPI) 115 mit CAN-Bus 219. Die Adresse 336 des Interface 115 wird einmalig über eine Parametriersoftware eingestellt.

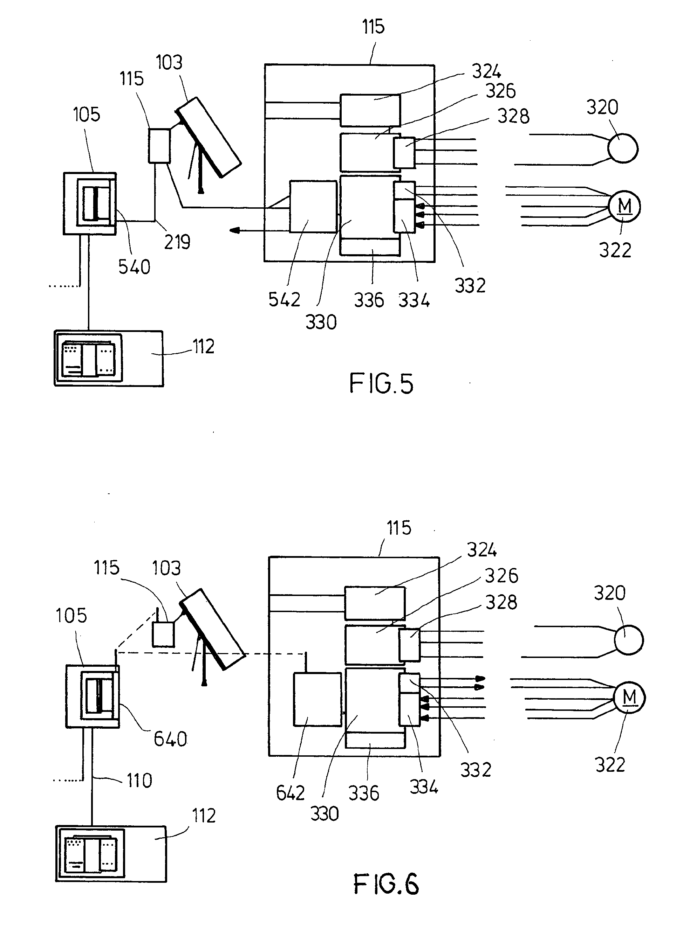

Fig. 5 zeigt eine Detaildarstellung des in Fig. 2 gezeigten Solarfelds gemäß einem Ausführungsbeispiel der vorliegenden Erfindung. Das in Fig. 5 gezeigte Ausführungsbeispiel entspricht dem in Fig. 4 gezeigten Ausführungsbeispiel mit dem Unterschied, dass der Bus 219 nicht als CAN-Bus sondern als Profibus ausgeführt ist. Entsprechend weist der Buskoppler 105 neben einem Sercos III-Bus bzw. einem Ethernet-Bus Kommunikationsmodul ein Profibus Kommunikationsmodul 540 auf. Das Steuergerät 115 weist dem Mikrocontroller 330 vorgeschaltet einen Profibus-Treiberbaustein 542 auf, der über Anschlüsse mit dem Profibus 219 verbunden ist.

Das Ausführungsbeispiel basiert auf einem Solar Peripherie Interface (SPI) 115 mit Profibus 219. Die Adresse 336 des Interface 115 wird einmalig über z. B. einen Dipschalteblock 8 Bit eingestellt.

Fig. 6 zeigt eine Detaildarstellung des in Fig. 2 gezeigten Solarfelds gemäß einem Ausführungsbeispiel der vorliegenden Erfindung. Das in Fig. 6 gezeigte Ausführungsbeispiel entspricht dem in Fig. 3 gezeigten Ausführungsbeispiel mit dem Unterschied, dass der Bus 219 nicht als CAN-Bus sondern als WLAN-Funkstrecke ausgeführt ist. Entsprechend weist der Buskoppler 105 neben einem Sercos III-Bus bzw. einem Ethernet-Bus

Kommunikationsmodul einen WLAN Router 640 auf. Das Steuergerät 115 weist dem Mikrocontroller 330 vorgeschaltet einen WLAN-Treiberbaustein 642, der mit dem WLAN Router 640 drahtlos verbunden ist.

Das Ausführungsbeispiel basiert auf einem Solar Peripherie Interface (SPI) 115 mit CAN-Bus 219. Die Adresse 336 des Interface 115 wird einmalig über eine Parametriersoftware eingestellt.

Das anhand der Figuren 4 bis 6 beschriebene Ausführungsbeispiel basiert auf einem Solar Peripherie Interface (SPI) 115.

Das Solar Peripherie Interface (SPI) 115 weist bezüglich des Antriebs 322 folgende Hauptfunktionen auf. Zum einen einen Empfang der Sollposition des Antriebs 322. Des weiteren ein Ansteuern der digitalen Ausgänge (L / R) zum Positionieren des Motors 322 auf die Sollposition. Ferner ein Einlesen und Zählen der Hall Impulse des Motors 322. Die IstPosition kann auch alternativ als Absolutwert über den analogen Eingang (Al) anliegen. Ferner umfassen die Hauptfunktionen ein Senden der aktuellen Istposition des Antriebs 322 an den Buskoppler 105 bzw. die SPS 112. Wenn er Endschalter betätigt ist, wird die Position des Antriebs 322 auf "0" gesetzt, also zurückgesetzt. Bei Busausfall erfolgt eine Ansteuerung des Motors 322 in eine definierte Position.

Das LIO-Bus Interface 215 weist bezüglich des Sensors 320 als Hauptfunktion das Senden eines Messwerts des Sensors 320 auf.

Die Positioniergeschwindigkeit ist unabhängig von der SPS-Zykluszeit der Steuerung 112, da die Positionierung des Antriebs 322 vom Mikrocontroller 330 nach Erhalt einer neuen Sollposition vorgenommen wird. Dadurch kann die SPS 112 eine viel höhere Anzahl an Teilnehmern 115 verwalten.

Im Folgenden wird anhand der Figuren 4 bis 6 ein Solar Peripherie Interface (SPI) mit CAN- oder Profibus- oder WLAN-Schnittstelle zum Ansteuern von Antrieben 322 und zur Messwerterfassung gemäß Ausführungsbeispielen der vorliegenden Erfindung beschrieben. Dabei findet ein Datenaustausch im Solarfeld zwischen Buskopplern 105 und elektrischen Antrieben 322 zur Minimierung der Verkabelungskosten statt. Als Basis kann ein zweiachsiges Trackingsystem für Heliostaten 103 mit Sercos III Schnittstelle zur Datenübertragung und Ansteuerung der Antriebe 322 eingesetzt werden. Das gezeigte Interface 115 dient sowohl zum Ansteuern von einem bis 128 langsam verstellbaren Antrieben 322 in Solarfeldern als auch zum Einlesen von Prozessmesswerten, wie Temperatur, Winkel, Strom oder Spannung. Dadurch ergeben sich eine Einsparung von Leitungs-, Hardware- (SPS analog IO, digital IO- bzw. Kommunikationsmodule) und Inbetriebnahmekosten. Es wird kein Buskoppler mit Direktverkabelung, d. h. die lokale Peripherie wird direkt an einen entsprechend mit IO-Modulen bestückten Buskoppler angeschlossen, eingesetzt. Dadurch können hohe Verkabelungs- bzw. Inbetriebnahmekosten sowie Kosten für analoge und digitale IO-Module vermieden werden. Stattdessen erfolgt eine Ansteuerung von mehreren tausend Antrieben 322 und eine Messwertaufnahme von diversen Messwertgebern 320 (Temperatur, Strom, Spannung, etc.) in einem Solarfeld bei geringstem Kosten- und Inbetriebnahmeaufwand. Das Interface 115 kommuniziert über einen CAN- oder Profibus 219 mit dem Ethernet / S3 Buskoppler 105. Beim Antrieb 322 wird ein Sollwert vorgegeben und das Interface 115 schaltet den Motor 322 ein bis die Position erreicht ist. Der Istwert geht an die SPS 112 zurück. Das Interface 115 verfügt neben den digitalen auch über analoge Ein- bzw. Ausgänge. Damit kann es auch Messwerte (4..20mA / 0 .. 10V) von z. B. Temperatursensoren 320 aufnehmen und an die Steuerung 112 senden. Das Interface 115 minimiert den Verkabelungs- und Hardwareaufwand in Solarfeldern. Darüber hinaus können auch Antriebsfunktionen, wie z. B. Grundstellung bei Busausfall, realisiert werden. Außerdem kann die SPS 112 eine höhere Anzahl an Teilnehmern verwalten.

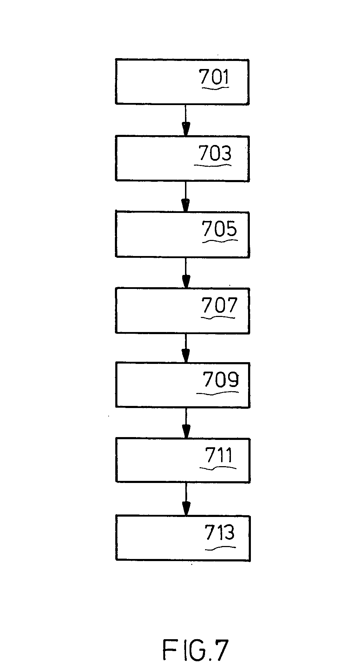

Fig. 7 zeigt ein Ablaufdiagramm eines Verfahrens zum Steuern eines Solarelements eines Solarfeldes mit einer Mehrzahl von Solarelementen. Das Verfahren kann beispielsweise von einem in den vorangegangenen Figuren beschriebenen Steuergerät 115 ausgeführt werden.

In einem Schritt 701 wird eine Mehrzahl von Steuersignalen über eine Kommunikationsschnittstelle, beispielsweise den CAN-Treiberbaustein, empfangen, wobei ein Steuersignal der Mehrzahl von Steuersignalen eine Adresse des Steuergeräts 115 aufweist. In einem Schritt 703 werden dem Steuersignal mit der Adresse des Steuergeräts Steuerdaten entnommen. In einem Schritt 705 werden basierend auf den Steuerdaten Antriebsdaten für einen Antrieb des Solarelements, beispielsweise für den gezeigten Motor 322 erzeugt. In einem Schritt 709 werden die Antriebsdaten für den Antrieb über eine Solarelementschnittstelle ausgegeben. In einem Schritt 711 werden Sensordaten, beispielsweise des Sensors 320 über die Solarelementschnittstelle empfangen. In einem Schritt 713 werden basierend auf den Sensordaten und der Adresse des Steuergeräts 115 Betriebsdaten erzeugt. In einem Schritt 715 werden die Betriebsdaten über die Kommunikationsschnittstelle, beispielsweise zu dem Buskoppler 105 oder direkt an die Steuervorrichtung 101 ausgegeben.

Die Erfindungen behandeln die Struktur von Feldbus und Sub-Bus-Systemen für Solaranlagen mit mehreren 1000 Aktuatoren. Bei einer Variante (LIO Interface) werden digitale I/0 Schnittstellen eines Standard Buskopplers zur Implementierung eines einfachen seriellen Buses genutzt. Ein weiteres Konzept basiert auf einer Implementierung des Sub-Buses 217 als CAN Bus.

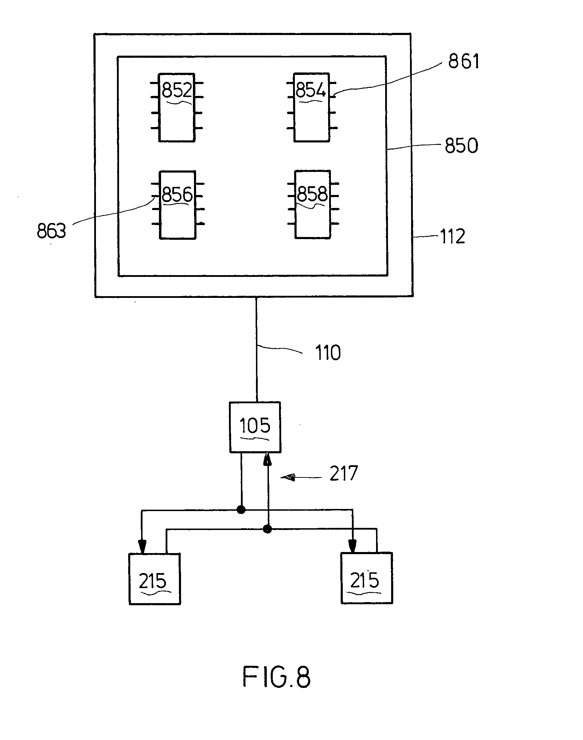

Fig. 8 zeigt ein Blockschaltbild einer Steuerung eines Solarfelds gemäß einem Ausführungsbeispiel der vorliegenden Erfindung. Gezeigt ist entsprechend zu den vorangegangenen Ausführungsbeispielen die speicherprogrammierbare Steuerung 112, die über den Bus 110 in Form eines SERCOS III / Ethernet-Bus mit einem Buskoppler 105 verbunden ist. Der Buskoppler 105 ist über einen Bus 217 in Form eines LIO-Bus mit einem Slave 1 und einem Slave 2, hier zwei Antriebe 215, verbunden. An dem Bus 110 können weitere nicht gezeigte Buskoppler und an den Bus 217 weitere nicht gezeigte Antriebe angeschlossen sein.

Die speicherprogrammierbare Steuerung 112 weist geeignete Einrichtung auf, um Programmschritte eines PLC-Programms 850 auszuführen. Das PLC-Programm 850 weist für jeden Bus 217 vier Funktionsbausteine auf, nämlich einen Master2Slave-Funktionsbaustein 852, einen LIO-Bus Send-Funktionsbaustein 854, einen LIO-Bus Receive-Funktionsbaustein 856 und einen Slave2Master-Funktionsbaustein 858. Die Funktionsbausteine 852, 854, 856, 858 weisen jeweils eine Mehrzahl von Eingängen und Ausgängen auf. Die Funktionsbausteine 852, 854, 856, 858 können in Hardware oder in Software realisiert sein. Der LIO-Bus Send-Funktionsbaustein 854 weist einen Send_bit Ausgang 861 auf, über den ein Signal BK_Master_SEND für einen digitalen LIO-Bus Ausgang des Buskopplers 105 bereitgestellt wird. Der LIO-Bus Receive-Funktionsbaustein 863 weist einen Receive_bit Eingang auf, über den ein Signal BK_Master_REC eines digitalen LIO-Bus Eingang des Buskopplers 105 eingelesen wird.

Im Folgenden wird anhand von Fig. 8 eine Umsetzung der Daten auf das lokale Bussystem 217 (LIO- Bus) beschrieben.

In der SPS 112 läuft ein Programm 850, welches das gesamte Solarfeld ansteuern kann. Das Programm 850 enthält eine eigene Task, (z.B. Zykluszeit 1ms), die den Datenaustausch mit dem lokalen Bussystem 217 regelt. Jedem LIO- Bus 217 ist ein digitaler Eingang und ein digitaler Ausgang am Buskoppler 105 in der Hardwarekonfiguration zugewiesen.

Der Sercos III Bus 110 liest an jedem Buskoppler 105 innerhalb der eingestellten Zykluszeit alle Peripherie Eingangssignale (DI) ein und schreibt alle Ausgangssignale (DO).

Für jeden LIO-Bus gibt es vier Funktionsbausteine 852, 854, 856, 858.

Der Baustein Master2Slave 852 ist ausgebildet, um den Antriebsbefehl und die Sollposition in die Befehls- und Positionsvariable des jeweils anzusteuernden Antriebs 215 bzw. der ausgewählten Adresse zu kopieren.

Der LIO- Bus Send Baustein 854 ist ausgebildet, um die zu sendenden Werte der Befehls- und Positionsvariable in das LIO-Bus Telegramm einzusetzen und das Telegramm über den digitalen Ausgang DO am Buskoppler BK 105 zum ausgewählten Antrieb (215) auszusenden.

Der Baustein LIO-Bus Receive 856 ist ausgebildet, um das vom Antrieb 215 zurückgesendete Telegramm zu entschlüsseln und die Werte in die Status- und Datenvariable zu kopieren. Das vom Antrieb 215 zurückgesendete Telegramm kann z. B. einen Antriebsstatus und Positionsistwert, einen Errorcode oder einen Messwert umfassen.

Der Baustein Slave2Master 858 ist ausgebildet, um den Wert der Status- und Datenvariable in die Status- und Datenvariable des angesteuerten Antriebs 215 bzw. der ausgewählten Adresse zu kopieren.

Nach Beendigung des Einlesens der Slave Antwort oder nach einer Wartezeit wird die Adresse inkrementiert und der nächste Antrieb 215 wird angesteuert. Diese Schritte werden werden für die einzelnen Antriebe 215 nacheinander wiederholt ausgeführt. Es findet keine direkte Telegramm Umwandlung zwischen Sercos III 110 und LIO-Bus 217 statt.

Gemäß einem Ausführungsbeispiel wird als Bus 217 ein CAN-Bus eingesetzt. Die Umsetzung der Daten auf das lokale Bussystem 217 in Form des CAN-Bus erfolgt prinzipiell in gleicher Weise wie beim LIO-Bus, nur dass die Funktionen des Send- und Receive Bausteins jetzt im CAN Treiber Funktionsbaustein bzw. im Kommunikationsmodul ablaufen. Dort wird das Telegramm auf die Klemmen CAN-High und CAN-Low gelegt anstatt auf (LIO Bus DI und DO).

Die gezeigten Ausführungsbeispiele sind nur beispielhaft gewählt und können miteinander kombiniert werden.

### Bezugszeichenliste

- 101: zentrale Steuerung
- 103: Solarelemente
- 105, 107, 109: Buskoppler
- 110: Bus
- 112: speicherprogrammierbare Steuerung
- 114: Bediensystem
- 203: Solarelemente
- 215: Antriebe
- 217,219: Busse
- 320: Sensor
- 322: Antrieb
- 324: Gleichstromwandler
- 326: Analog-Digital-Wandler
- 328: Analog Input
- 330: Mikrocontroller
- 332: Digital Output
- 334: Digital Input
- 336: Adresse
- 440: CAN Kommunikationsmodul
- 442: CAN-Teiberbaustein
- 540: Profibus Kommunikationsmodul
- 542: Profibus-Teiberbaustein
- 640: WLAN Router
- 642: WLAN-Teiberbaustein
- 701: Verfahrensschritt
- 703: Verfahrensschritt
- 705: Verfahrensschritt
- 707: Verfahrensschritt
- 709: Verfahrensschritt
- 711: Verfahrensschritt
- 713: Verfahrensschritt
- 715: Verfahrensschritt
- 850: Programm
- 852: Baustein Master2Slave
- 854: LIO- Bus Send Baustein
- 856: Baustein LIO- Bus Receive
- 858: Baustein Slave2Master
- 861: Ausgang
- 863: Eingang

## Patentansprüche

1. Steuergerät (115) für ein Solarelement (103) eines Solarfeldes mit einer Mehrzahl von Solarelementen (103, 203) und einer Mehrzahl von Steuergeräten (115), mit folgenden Merkmalen:
einer Solarelementschnittstelle zum Empfangen von Sensordaten des Solarelements (103) und zum Ausgeben von Antriebsdaten für einen Antrieb (322) des Solarelements;
einer Kommunikationsschnittstelle (442, 542, 642) zum Empfangen einer Mehrzahl von Steuersignalen für die Mehrzahl von Steuergeräten für die Mehrzahl von Solarelementen und zum Ausgeben von Betriebsdaten des Solarelements, wobei ein Steuersignal der Mehrzahl von Steuersignalen jeweils eine Adresse (336) eines der Mehrzahl von Steuergeräten umfasst und wobei die Betriebsdaten die Adresse des Steuergeräts umfassen; und
einer Verarbeitungseinrichtung (330), die ausgebildet ist, um aus einem der Mehrzahl von Steuersignalen dem die Adresse des Steuergeräts zugeordnet ist Steuerdaten zu entnehmen und basierend auf den Steuerdaten die Antriebsdaten zu erzeugen und die ferner ausgebildet ist, um basierend auf den Sensordaten und der Adresse des Steuergeräts die Betriebsdaten zu erzeugen.

2. Steuergerät (115) gemäß Anspruch 1, bei dem die Kommunikationsschnittstelle (442, 542, 642) eine digitale Schnittstelle ist, und bei dem die Solarelementschnittstelle mindestens eine digitale Schnittstelle und mindestens eine analoge Schnittstelle umfasst.

3. Steuergerät (115) gemäß einem der vorangegangenen Ansprüche, mit einer Eingabeschnittstelle zum Eingeben der Adresse (336) des Steuergeräts (115) und einem Speicher zum Speichern der Adresse.

4. Steuergerät (115) gemäß einem der vorangegangenen Ansprüche, bei dem die Steuerdaten einen Sollwert für den Antrieb (322) des Solarelements (103) umfassen und die Verarbeitungseinrichtung (330) ausgebildet ist, um die Antriebsdaten zum Einstellen des Antriebs auf den Sollwert zu erzeugen, und bei dem die Sensordaten einen Istwert des Antriebs umfassen und die Verarbeitungseinrichtung ausgebildet ist, um den Istwert in die Betriebsdaten einzufügen.

5. Steuergerät (115) gemäß einem der vorangegangenen Ansprüche, bei dem die Kommunikationsschnittstelle (442, 542, 642) ausgebildet ist, um eine Mehrzahl von Datenpaketen zu empfangen und wieder auszugeben, wobei ein Datenpaket jeweils eine Adresse (336) eines der Mehrzahl von Steuergeräten umfasst, und wobei die Verarbeitungseinrichtung ausgebildet ist, um die Steuerdaten aus einem Datenpaket, dem die Adresse des Steuergeräts (115) zugeordnet ist zu entnehmen und die Betriebsdaten in das Datenpaket einzufügen, dem die Adresse des Steuergeräts zugeordnet ist.

6. Steuergerät (115) gemäß einem der vorangegangenen Ansprüche, bei dem die Kommunikationsschnittstelle (442, 542, 642) eine Profi-Bus-Schnittelle, eine CAN-Bus-Schnittelle oder eine WLAN-Schnittelle ist.

7. Steuersystem für ein Solarfeld mit einer Mehrzahl von Solarelementen (103, 203), mit folgenden Merkmalen:
einer Mehrzahl von Steuergeräten (115) gemäß einem der Ansprüche 1 bis 6, wobei eines der Mehrzahl von Steuergeräten jeweils einem der Mehrzahl von Solarelementen zugeordnet ist und eine Adresse (336) des Steuergeräts (115) aufweist; und
einer Steuervorrichtung (112) zum Steuern der Mehrzahl von Solarelementen, wobei die Steuervorrichtung eine weitere Kommunikationsschnittstelle aufweist, zum Empfangen einer Mehrzahl von Betriebsdaten von der Mehrzahl von Steuergeräten und zum Ausgeben der Mehrzahl von Steuersignalen für die Mehrzahl von Solarelementen an die Mehrzahl von Steuergeräten.

8. Steuersystem gemäß Anspruch 7, bei dem die Mehrzahl von Solarelementen (103, 203) in eine Anzahl von Gruppen von Solarelementen unterteilt ist und das Steuersystem eine der Anzahl von Gruppen entsprechende Anzahl von Verteilern (105, 107, 109) aufweist, die über einen gemeinsamen Datenübertragungsweg (217, 219) mit der Steuervorrichtung verbunden sind, wobei einem Verteiler jeweils eine der Anzahl von Gruppen von Solarelementen zugeordnet ist und ein Verteiler jeweils ausgebildet ist, um aus der Mehrzahl von Steuersignalen für die Mehrzahl von Solarelementen diejenigen Steuersignale, die Solarelementen der dem Verteiler zugeordneten Gruppe von Solarelementen zugeordnet sind, an die Steuergeräte (115) der dem Verteiler zugeordneten Gruppe von Solarelementen weiterzuleiten, und ausgebildet ist, um die Betriebsdaten der dem Verteiler zugeordneten Gruppe von Solarelementen zu empfangen und an die Steuervorrichtung weiterzuleiten.

9. Solarfeld mit folgenden Merkmalen:
einer Mehrzahl von Solarelementen (103, 203), wobei jedes Solarelement ein Steuergerät (115) gemäß einem der Ansprüche 1 bis 6 aufweist; und
einem Steuersystem für ein Solarfeld gemäß einem der Ansprüche 7 oder 8, das mit den Steuergeräten (115) gekoppelt ist.

10. Verfahren zum Steuern eines Solarelements (103) eines Solarfeldes mit einer Mehrzahl von Solarelementen (103, 203) und einer Mehrzahl von Steuergeräten (115), das die folgenden Schritte umfasst:
Empfangen (701) einer Mehrzahl von Steuersignalen für die Mehrzahl von Steuergeräten für die Mehrzahl von Solarelementen über eine Kommunikationsschittstelle (442, 542, 642) eines Steuergeräts (105) des zu steuernden Solarelements (103), wobei ein Steuersignal der Mehrzahl von Steuersignalen jeweils eine Adresse eines der Mehrzahl von Steuergeräten umfasst;
Entnehmen (703) von Steuerdaten aus einem der Mehrzahl von Steuersignalen dem eine (336) Adresse des Steuergeräts des zu steuernden Solarelements zugeordnet ist;
Erzeugen (705) von Antriebsdaten für einen Antrieb (322) des zu steuernden Solarelements basierend auf den Steuerdaten;
Ausgeben (707) der Antriebsdaten für den Antrieb des zu steuernden Solarelements über eine Solarelementschnittstelle des Steuergeräts des zu steuernden Solarelements;
Empfangen (709) von Sensordaten des zu steuernden Solarelements über die Solarelementschnittstelle;
Erzeugen (711) von Betriebsdaten, die die Adresse des Steuergeräts des zu steuernden Solarelements umfassen basierend auf den Sensordaten und der Adresse des Steuergeräts des zu steuernden Solarelements; und
Ausgeben (713) der Betriebsdaten des zu steuernden Solarelements über die Kommunikationsschnittstelle.
